# EUROPEAN PATENT APPLICATION

(11) **EP 4 807 386 A2**
(43) Date of publication of application: **16.09.2026**
(21) Application number: 26163985.0
(22) Date of filing: 11.03.2026
(51) Int. Cl.: G01R 33/561, G01R 33/565

(54) **MAGNETIC RESONANCE IMAGING APPARATUS AND MAGNETIC RESONANCE IMAGING METHOD**

(30) Priority: 11.03.2025 CN 202510283159; 21.08.2025 JP 2025138130
(71) Applicant: Canon Medical Systems Corporation, Tochigi 324-0036 (JP)
(72) Inventor: KUTSUNA, Hideaki, Otawara-shi, 324-0036 (JP); BEKKU, Mitsuhiro, Otawara-shi, 324-0036 (JP); ZHANG, Lijun, Beijing (CN); WANG, Sha, Beijing (CN); SHINODA, Kensuke, Otawara-shi, 324-0036 (JP)
(74) Representative: Marks & Clerk LLP

(57) **Abstract**

A magnetic resonance imaging apparatus (100) according to an embodiment includes a processing circuit (150). The processing circuit (150) generates a first sensitivity map (11) based on magnetic resonance data (10), generates a first reconstructed image (12) by performing reconstruction based on the first sensitivity map (11), generates a second sensitivity map (13) based on the first reconstructed image (12) and the first sensitivity map (11), and generates a second reconstructed image (14) by reconstructing the magnetic resonance data (10) based on the second sensitivity map (13).

## Description

### FIELD

Embodiments described herein relate generally to a magnetic resonance imaging apparatus and a magnetic resonance imaging method.

### BACKGROUND

As a new approach to reconstruct a magnetic resonance image from k-space data collected by a plurality of coils using parallel imaging, an ESPIRiT method ("An Eigenvalue Approach to Autocalibrating Parallel MRI: Where SENSE Meets GRAPPA", Martin Uecker et. al., Magnetic Resonance in Medicine 71: 990-1001 (2014)) is exemplified. The ESPIRiT method is a reconstruction method for performing self-calibration of a sensitivity map by an approach using a singular value in parallel imaging of MRI. The ESPIRiT method is an approach using a singular value/vector for calculating a sensitivity map of a coil by mainly using data of a center portion of a k-space from k-space data collected by a plurality of coils from an object to be imaged.

However, the ESPIRiT method is a method for calculating the sensitivity map of the coil using a singular vector, so that only relative values of the sensitivity map among the coils can be calculated by the ESPIRiT method, and a phase of the sensitivity map belongs to the relative values among the coils. That is, regarding the phase of the sensitivity map and the like, an absolute value cannot be directly calculated within a framework of the ESPIRiT method.

### BRIEF DESCRIPTION OF THE DRAWINGS

FIG. 1 is a diagram illustrating an example of a magnetic resonance imaging apparatus according to an embodiment;
FIG. 2 is a diagram illustrating an example of a processing procedure performed by a magnetic resonance imaging apparatus 100 according to a first embodiment;
FIG. 3 is a diagram for explaining processing performed by the magnetic resonance imaging apparatus 100 according to the first embodiment;
FIG. 4 is a flowchart for explaining a processing procedure at Step S200 in FIG. 2 in more detail;
FIG. 5 is a flowchart for explaining processing at Step S200 in FIG. 2;
FIG. 6 is a flowchart for explaining an example of a processing procedure performed by the magnetic resonance imaging apparatus 100 according to a second embodiment;
FIG. 7 is a diagram for explaining processing performed by the magnetic resonance imaging apparatus 100 according to the second embodiment; and
FIG. 8 is a diagram for explaining processing performed by the magnetic resonance imaging apparatus 100 according to a third embodiment.

### SUMMARY OF INVENTION

A magnetic resonance imaging apparatus according to a present invention includes a processing circuit. The processing circuit is configured to generate a first sensitivity map based on magnetic resonance data, generate a first reconstructed image by performing reconstruction based on the first sensitivity map, generate a second sensitivity map based on the first reconstructed image and the first sensitivity map, and generate a second reconstructed image by reconstructing the magnetic resonance data based on the second sensitivity map.

The processing circuit may generate the first sensitivity map based on the magnetic resonance data as k-space data that is collected by a plurality of coils from an object to be imaged.

The processing circuit may generate the second sensitivity map by correcting indeterminacy of the first sensitivity map.

The processing circuit may generate the first sensitivity map by using an ESPIRiT method for the magnetic resonance data.

The processing circuit may generate the first reconstructed image by reconstructing the magnetic resonance data based on the first sensitivity map.

The processing circuit may generate the first reconstructed image by reconstructing data obtained by extracting data in a vicinity of a center of a k-space from the magnetic resonance data based on the first sensitivity map.

The processing circuit may generate the first reconstructed image by performing SENSE reconstruction on a third sensitivity map based on the first sensitivity map.

The third sensitivity map may be a sensitivity map obtained by scanning other than scanning for the magnetic resonance data.

The processing circuit may generate the second sensitivity map by multiplying the first sensitivity map by a correction amount that is obtained based on a phase portion of the first reconstructed image.

The processing circuit may generate a third reconstructed image by performing iterative reconstruction based on the magnetic resonance data, the second sensitivity map, and the second reconstructed image, and perform reconstruction based on the second sensitivity map at each step of the iterative reconstruction.

A magnetic resonance imaging method provided according to an aspect of the present invention comprises: generating a first sensitivity map based on magnetic resonance data; generating a first reconstructed image by performing reconstruction based on the first sensitivity map; generating a second sensitivity map based on the first reconstructed image and the first sensitivity map; and generating a second reconstructed image by reconstructing the magnetic resonance data based on the second sensitivity map.

### DETAILED DESCRIPTION

A magnetic resonance imaging apparatus according to an embodiment includes a processing circuit. The processing circuit generates a first sensitivity map based on magnetic resonance data, generates a first reconstructed image by performing reconstruction based on the first sensitivity map, generates a second sensitivity map based on the first reconstructed image and the first sensitivity map, and generates a second reconstructed image by reconstructing the magnetic resonance data based on the second sensitivity map.

The following describes embodiments of the magnetic resonance imaging apparatus and a magnetic resonance imaging method in detail with reference to the drawings.

### First embodiment

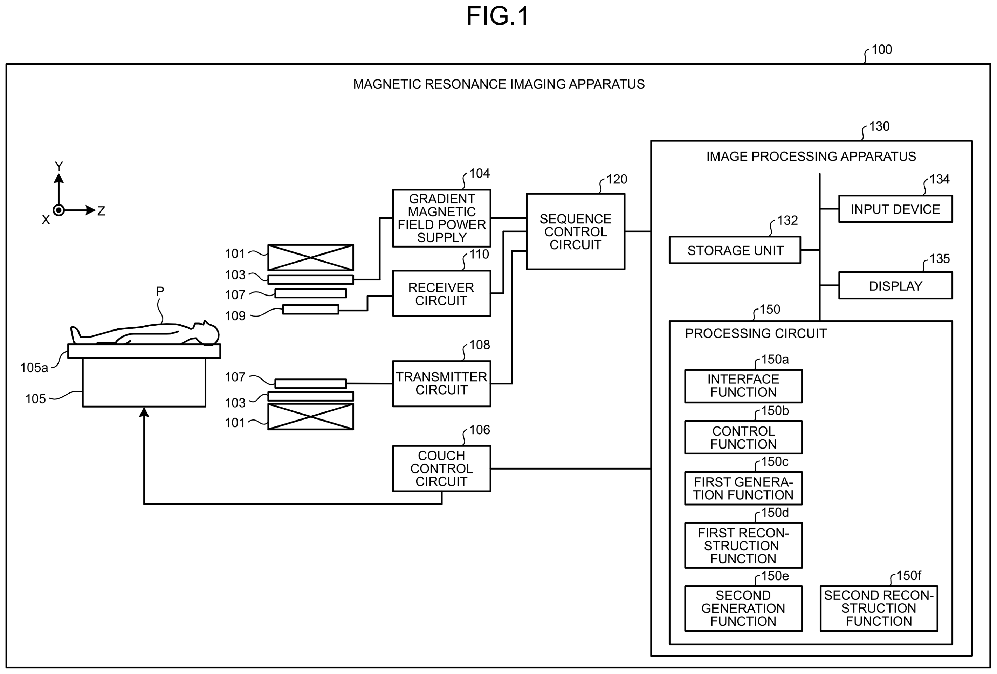

FIG. 1 is a block diagram illustrating a magnetic resonance imaging apparatus 100 according to a first embodiment.

As illustrated in FIG. 1, the magnetic resonance imaging apparatus 100 includes a static magnetic field magnet 101, a static magnetic field power supply (not illustrated), a gradient coil 103, a gradient magnetic field power supply 104, a couch 105, a couch control circuit 106, a transmitter coil 107, a transmitter circuit 108, a receiver coil 109, a receiver circuit 110, a sequence control circuit 120 (sequence control unit), and an image processing apparatus 130 (also referred to as an "image management device"). The magnetic resonance imaging apparatus 100 does not include a subject P (for example, a human body). The configuration illustrated in FIG. 1 is merely an example. For example, components in the sequence control circuit 120 and the image processing apparatus 130 may be appropriately configured in an integrated or separated manner.

The static magnetic field magnet 101 is a magnet formed in a substantially cylindrical hollow shape, and generates a static magnetic field in an internal space. The static magnetic field magnet 101 is, for example, a superconducting magnet and the like. As another example, the static magnetic field magnet 101 may be a permanent magnet.

The gradient coil 103 is a coil formed in a substantially cylindrical hollow shape, and is arranged on an inner side of the static magnetic field magnet 101. The gradient coil 103 is formed by combining three coils respectively corresponding to X, Y, and Z axes orthogonal to each other, and these three coils individually receive a current from the gradient magnetic field power supply 104, and generate gradient magnetic fields in which magnetic field strength changes along each of the X, Y, and Z axes. The gradient magnetic fields of each of the X, Y, and Z axes generated by the gradient coil 103 is, for example, a gradient magnetic field Gs for slicing, a gradient magnetic field Ge for phase encoding, and a gradient magnetic field Gr for readout. The gradient magnetic field power supply 104 supplies a current to the gradient coil 103.

The couch 105 includes a couchtop 105a on which the subject P is placed, and the couchtop 105a is inserted into a cavity (imaging port) of the gradient coil 103 while the subject P is placed thereon under control by the couch control circuit 106. Normally, the couch 105 is installed so that a longitudinal direction is parallel with a center axis of the static magnetic field magnet 101. The couch control circuit 106 drives the couch 105 to move the couchtop 105a in the longitudinal direction and an upper and lower direction under control by the image processing apparatus 130.

The transmitter coil 107 is arranged on an inner side of the gradient coil 103, and receives RF pulses supplied from the transmitter circuit 108 to generate a high-frequency magnetic field. The transmitter circuit 108 supplies, to the transmitter coil 107, an RF pulse corresponding to a Larmor frequency that is determined based on a type of a target atom and magnetic field strength.

The receiver coil 109 is arranged on the inner side of the gradient coil 103, and receives a magnetic resonance signal (hereinafter, referred to as an "MR signal" as needed) emitted from the subject P due to influence of the high-frequency magnetic field. When receiving the magnetic resonance signal, the receiver coil 109 outputs the received magnetic resonance signal to the receiver circuit 110.

The transmitter coil 107 and the receiver coil 109 described above are merely examples. One or more of a coil including only a transmission function, a coil including only a reception function, and a coil including a transmission and reception function may be combined.

The receiver circuit 110 detects the magnetic resonance signal output from the receiver coil 109, and generates magnetic resonance data based on the detected magnetic resonance signal. Specifically, the receiver circuit 110 generates magnetic resonance data by digitally converting the magnetic resonance signal output from the receiver coil 109. The receiver circuit 110 transmits the generated magnetic resonance data to the sequence control circuit 120. The receiver circuit 110 may be provided on a platform device side including the static magnetic field magnet 101, the gradient coil 103, and the like. Furthermore, part of the function of the receiver circuit 110, for example, a function of digital conversion of the magnetic resonance signal, may be provided in the receiver coil 109.

The sequence control circuit 120 images the subject P by driving the gradient magnetic field power supply 104, the transmitter circuit 108, and the receiver circuit 110 based on sequence information transmitted from the image processing apparatus 130. Herein, the sequence information is information that defines a procedure for performing imaging. The sequence information defines strength of the current supplied from the gradient magnetic field power supply 104 to the gradient coil 103 and a timing for supplying the current, strength of the RF pulse supplied from the transmitter circuit 108 to the transmitter coil 107 and a timing for applying the RF pulse, a timing for detecting the magnetic resonance signal by the receiver circuit 110, and the like.

For example, the sequence control circuit 120 is an integrated circuit such as an application specific integrated circuit (ASIC) and a field programmable gate array (FPGA), or an electronic circuit such as a central processing unit (CPU) and a micro processing unit (MPU). Details of a pulse sequence performed by the sequence control circuit 120 will be described later.

Furthermore, as a result of imaging the subject P by driving the gradient magnetic field power supply 104, the transmitter circuit 108, and the receiver circuit 110, when receiving the magnetic resonance data from the receiver circuit 110, the sequence control circuit 120 transfers the received magnetic resonance data to the image processing apparatus 130.

The image processing apparatus 130 performs overall control of the magnetic resonance imaging apparatus 100, generation of an image, and the like. The image processing apparatus 130 includes a storage unit 132, an input device 134, a display 135, and a processing circuit 150. The processing circuit 150 includes an interface function 150a, a control function 150b, a first generation function 150c, a first reconstruction function 150d, a second generation function 150e, and a second reconstruction function 150f.

In the first embodiment, respective processing functions executed by the interface function 150a, the control function 150b, the first generation function 150c, the first reconstruction function 150d, the second generation function 150e, and the second reconstruction function 150f are stored in the storage unit 132 in a form of a computer-executable program. The processing circuit 150 is a processor that implements a function corresponding to each computer program by reading out, from the storage unit 132, and executing the computer program. In other words, the processing circuit 150 that has read out each computer program has a corresponding one of the functions illustrated in the processing circuit 150 in FIG. 1. In FIG. 1, it is assumed that the single processing circuit 150 implements the processing functions executed by the interface function 150a, the control function 150b, the first generation function 150c, the first reconstruction function 150d, the second generation function 150e, and the second reconstruction function 150f. Alternatively, the processing circuit 150 may be configured by combining a plurality of independent processors, and each of the processors may execute the computer program to implement the function. In other words, each of the functions described above may be configured as a computer program, and the one processing circuit 150 may execute each computer program. As another example, a specific function may be implemented in a dedicated independent program execution circuit. In FIG. 1, the interface function 150a, the control function 150b, the first generation function 150c, the first reconstruction function 150d, the second generation function 150e, and the second reconstruction function 150f are examples of an interface unit, a control unit, a first generation unit, a first reconstruction unit, a second generation unit, and a second reconstruction unit, respectively. The sequence control circuit 120 is an example of a sequence control unit.

A term of "processor" used in the above description means a central processing unit (CPU), a graphical processing unit (GPU), or a circuit such as an application specific integrated circuit (ASIC) or a programmable logic device (for example, a simple programmable logic device (SPLD), a complex programmable logic device (CPLD), and a field programmable gate array (FPGA)). The processor implements a function by reading out and executing a computer program stored in the storage unit 132.

Instead of storing the computer program in the storage unit 132, the computer program may be directly incorporated in a circuit of the processor. In this case, the processor implements the function by reading out and executing the computer program incorporated in the circuit. The couch control circuit 106, the transmitter circuit 108, the receiver circuit 110, and the like are similarly configured of an electronic circuit such as the processor described above.

The processing circuit 150 transmits the sequence information to the sequence control circuit 120 by the interface function 150a, and receives magnetic resonance data from the sequence control circuit 120. When receiving the magnetic resonance data, the processing circuit 150 including the interface function 150a stores the received magnetic resonance data in the storage unit 132.

The processing circuit 150 performs overall control of the magnetic resonance imaging apparatus 100 by the control function 150b, and controls imaging, generation of an image, display of an image, and the like. For example, the processing circuit 150 including the control function 150b receives input of an imaging condition (imaging parameters and the like) on a GUI, and generates sequence information in accordance with the received imaging condition. The processing circuit 150 including the control function 150b transmits the generated sequence information to the sequence control circuit 120.

The processing circuit 150 performs image reconstruction based on the k-space data, which is collected by the coils, by the first generation function 150c, the first reconstruction function 150d, the second generation function 150e, and the second reconstruction function 150f. Details of these pieces of processing will be described later.

The magnetic resonance data stored in the storage unit 132 is arranged in the k-space by the control function 150b. As a result, the storage unit 132 stores the k-space data.

The storage unit 132 stores the magnetic resonance data received by the processing circuit 150 including the interface function 150a, the k-space data arranged in the k-space by the processing circuit 150 including the control function 150b, generated imaging data, and the like. For example, the storage unit 132 is configured of a semiconductor memory element such as a random access memory (RAM) and a flash memory, a hard disk, an optical disc, and the like.

The input device 134 receives various instructions and information input from an operator. The input device 134 is, for example, a pointing device such as a mouse and a trackball, a selection device such as a mode changeover switch, or an input device such as a keyboard. The display 135 displays a graphical user interface (GUI) for receiving input of an imaging condition, a generated image, and the like under control by the processing circuit 150 including the control function 150b. The display 135 is, for example, a display device such as a liquid crystal display.

Subsequently, the following describes a background related to the embodiment.

As a new approach to reconstruct the magnetic resonance image from the k-space data collected by the coils using parallel imaging, the ESPIRiT method can be exemplified. The ESPIRiT method is a reconstruction method for performing self-calibration of a sensitivity map by an approach using a singular value in parallel imaging of MRI. In the ESPIRiT method, a sensitivity map of a coil is calculated by mainly using data of a center portion of the k-space from the k-space data collected by the coils from an object to be imaged.

However, the ESPIRiT method is a method for calculating the sensitivity map of the coil using a singular vector, so that only relative values of the sensitivity map among the coils can be calculated by the ESPIRiT method, and a phase of the sensitivity map belongs to the relative values among the coils. That is, regarding the phase of the sensitivity map and the like, an absolute value cannot be directly calculated within a framework of the ESPIRiT method, so that the absolute value needs to be separately calculated by some method. Herein, in practical applications, as indicated by the following expression (1), for example, one of calculated coil maps, for example, a sensitivity map of a first coil, is used as reference data of the phase, and normalization of the coil map has been performed by using it. ${S}^{j} = {\hat{S}}^{j} ∗ {e}^{- iϕ \left({\hat{S}}^{0}\right)}$

Herein, Sⁱ in a left side of the expression (1) indicates the sensitivity map of the coil after the normalization is performed, and j indicates a coil number. S^^{j} in a right side indicates the sensitivity map of the coil before the normalization is performed, S^⁰ indicates the sensitivity map of the 0-th coil, and φ indicates a phase portion.

However, in this method, an artifact may be caused in the following case, for example. That is, for example, in a case where the phase of the reference data is indeterminate due to insufficient sensitivity, the phase of the sensitivity map of the normalized coil becomes discontinuous, and a signal loss what is called a Phase-pole artifact may be caused. Even if the sensitivity map is smooth, a large phase variation appears in the reconstructed image due to an initial phase of a reference sensitivity map, and as a result, a band-like or ripple-like artifact may appear in some cases.

The embodiment is based on such a background, and the sensitivity map is corrected based on the reconstructed image that has been obtained by performing tentative reconstruction.

That is, the magnetic resonance imaging apparatus 100 according to the embodiment includes the processing circuit 150. The processing circuit 150 generates the first sensitivity map based on the magnetic resonance data by the first generation function 150c. The processing circuit 150 generates the first reconstructed image by performing reconstruction based on the first sensitivity map by the first reconstruction function 150d. The processing circuit 150 generates the second sensitivity map based on the first reconstructed image and the first sensitivity map by the second generation function 150e. The processing circuit 150 generates the second reconstructed image by reconstructing the magnetic resonance data based on the second sensitivity map by the second reconstruction function 150f.

In the magnetic resonance imaging method according to the embodiment, the first sensitivity map is generated based on the magnetic resonance data, the first reconstructed image is generated by performing reconstruction based on the first sensitivity map, the second sensitivity map is generated based on the first reconstructed image and the first sensitivity map, and the second reconstructed image is generated by reconstructing the magnetic resonance data based on the second sensitivity map.

Due to this, it is possible to reduce artifacts caused by indeterminacy that appears in calculation of the sensitivity map in the ESPIRiT method, and image quality can be improved.

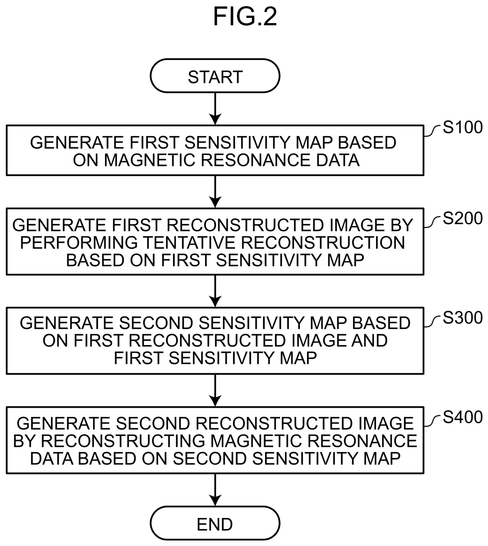

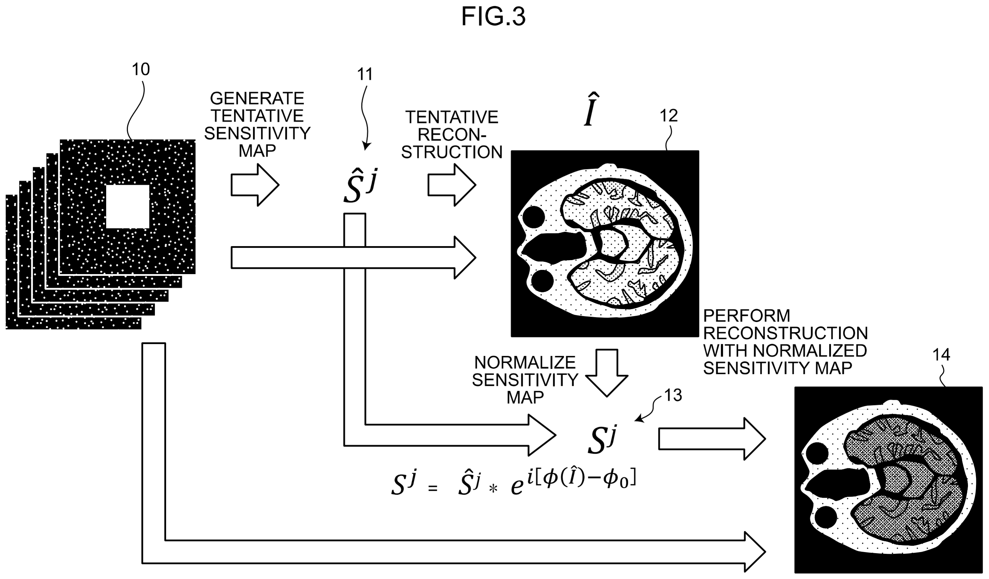

The following describes details of the configuration with reference to FIG. 2 to FIG. 5. FIG. 2 is a diagram illustrating an example of a processing procedure performed by the magnetic resonance imaging apparatus 100 according to the first embodiment, and FIG. 3 is a diagram for explaining processing performed by the magnetic resonance imaging apparatus 100 according to the first embodiment.

First, at Step S100, the processing circuit 150 generates the first sensitivity map based on the magnetic resonance data by the first generation function 150c. By way of example, as illustrated in FIG. 3, the processing circuit 150 generates a first sensitivity map 11 using the ESPIRiT method based on magnetic resonance data 10 by the first generation function 150c. Herein, the magnetic resonance data 10 as a source for generating the first sensitivity map 11 is, for example, the k-space data collected by the coils from the object to be imaged. The processing circuit 150 calculates the first sensitivity map 11 in accordance with a predetermined minimization condition based on the magnetic resonance data 10 as the k-space data collected by the coils from the object to be imaged using the ESPIRiT method by the first generation function 150c. Of the magnetic resonance data 10, data substantially in the vicinity of the center of the k-space contributes to a value of the sensitivity map, and the first sensitivity map 11 is generated accordingly.

In the ESPIRiT method, the first sensitivity map 11 is generated from the magnetic resonance data 10 as the k-space data collected by the coils from the object to be imaged, so that the first sensitivity map 11 does not need to be measured separately from the magnetic resonance data 10.

The method for generating the first sensitivity map 11 at Step S100 is not limited to the ESPIRiT method. For example, the first sensitivity map 11 may be generated by collecting auto-calibration signals (ACS) based on the data in the vicinity of the center of the k-space of the magnetic resonance data 10, for example.

The ESPIRiT method is a method for calculating the sensitivity map based on a singular vector, so that the first generation function 150c can only determine a ratio in sensitivity maps between different coils at Step S100, and the first sensitivity map 11 has indeterminacy in the phase portion. Thus, the first sensitivity map 11 is called a tentative sensitivity map as compared with a second sensitivity map 13 (described later) in which indeterminacy of the first sensitivity map 11 is corrected.

Subsequently, at Step S200, the processing circuit 150 generates a first reconstructed image 12 by performing tentative reconstruction based on the first sensitivity map 11 by the first reconstruction function 150d.

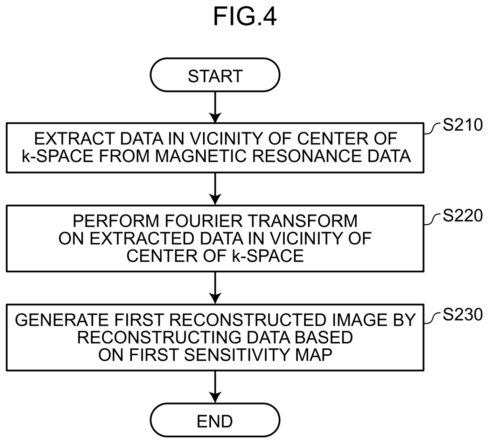

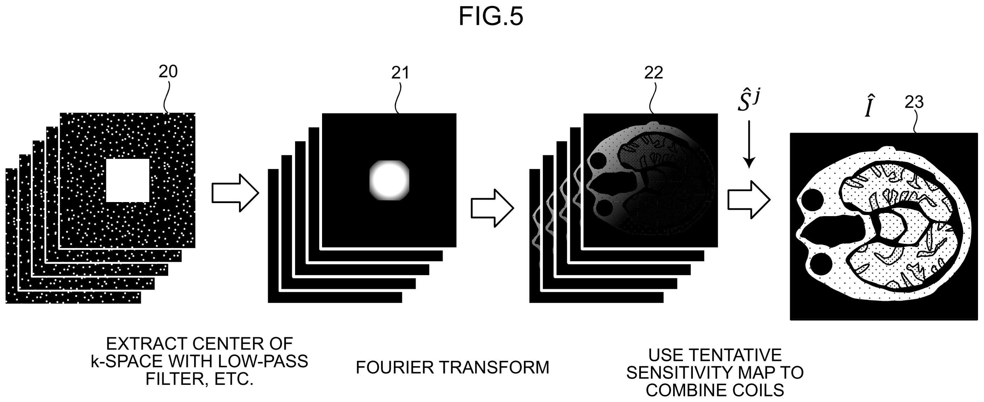

With reference to FIG. 4 and FIG. 5, the following describes the processing at Step S200 in more detail. FIG. 4 is a flowchart for explaining the processing procedure at Step S200 in FIG. 2 in more detail, and Step S210 to Step S230 in FIG. 4 correspond to Step S200 in FIG. 2. FIG. 5 is a diagram for explaining the processing at Step S200 in FIG. 2.

At Step S210, the processing circuit 150 extracts data 21 in the vicinity of the center of the k-space, for example, from magnetic resonance data 20 by applying a low-pass filter to the magnetic resonance data 20, for example, by the first reconstruction function 150d. The magnetic resonance data 20 is, for example, the k-space data collected by the coils. Herein, the magnetic resonance data 20 may be the same as or different from the magnetic resonance data 10. In the first embodiment, the magnetic resonance data 20 is assumed to be the same as the magnetic resonance data 10. In this case, the processing circuit 150 extracts the data 21 in the vicinity of the center of the k-space from the magnetic resonance data 10 by the first reconstruction function 150d.

Subsequently, at Step S220, the processing circuit 150 performs Fourier transform on the data 21 in the vicinity of the center of the k-space extracted at Step S210 by the first reconstruction function 150d to obtain image data 22 related to the coils. The magnetic resonance data 20 is the k-space data related to the coils, while the image data 22 is data of an image space obtained by performing Fourier transform on the k-space data, and is data related to the coils.

Subsequently, at Step S230, the processing circuit 150 generates the first reconstructed image by reconstructing data based on the first sensitivity map by the first reconstruction function 150d. That is, the processing circuit 150 generates, as the first reconstructed image 12 in FIG. 2, an image 23 obtained by combining, with respect to the coils, the image data 22 related to the coils based on the first sensitivity map 11.

In this manner, the processing circuit 150 generates the image 23 as the first reconstructed image 12 by reconstructing the data 21 obtained by extracting the data in the vicinity of the center of the k-space from the magnetic resonance data 20 (magnetic resonance data 10) based on the first sensitivity map 11 by the first reconstruction function 150d.

The reconstruction processing at Step S200 is only processing for generating an image to correct the sensitivity map, so that it may be simpler than reconstruction processing at Step S400 described later. That is, the reconstruction processing at Step S200 is tentative as compared with the reconstruction processing at Step S400.

Returning to FIG. 2, subsequently, at Step S300, the processing circuit 150 generates the second sensitivity map 13 based on the first reconstructed image 12 and the first sensitivity map 11 by the second generation function 150e.

Herein, a relation between the second sensitivity map 13 and the first sensitivity map 11 is represented by the following expression (2). ${S}^{j} = {\hat{S}}^{j} ∗ {e}^{i \left[ϕ\left(\hat{I}\right)-{ϕ}_{0}\right]}$

Herein, S^{j} in a left side of the expression (2) represents the second sensitivity map 13, and S^^{j} in the first term of a right side of the expression (2) represents the first sensitivity map 11. I^ represents the first reconstructed image 12, and φ represents a phase component thereof. Additionally, φ₀ is a reference phase. The reference phase is 0 or a phase obtained by other collection, for example, Whole Body Coil collection.

In other words, at Step S300, the processing circuit 150 generates the second sensitivity map 13 by multiplying the first sensitivity map 11 by a correction amount that is obtained based on a phase portion of the first reconstructed image 12 by the second generation function 150e. As described above, the first sensitivity map 11 has phase indeterminacy due to the ESPIRiT method. The processing circuit 150 generates the second sensitivity map 13 by correcting indeterminacy of the first sensitivity map 11 by the second generation function 150e.

Subsequently, at Step S400, the processing circuit 150 generates a second reconstructed image 14 by reconstructing the magnetic resonance data 10 based on the second sensitivity map 13 obtained at Step S300 by the second reconstruction function 150f.

As described above, in the first embodiment, the processing circuit 150 generates the first reconstructed image 12 by performing reconstruction based on the first sensitivity map 11 by the first reconstruction function 150d, generates the second sensitivity map 13 based on the first reconstructed image 12 and the first sensitivity map 11 by the second generation function 150e, and generates the second reconstructed image 14 by reconstructing the magnetic resonance data 10 based on the second sensitivity map 13 by the second reconstruction function 150f. Due to this, the phase of the sensitivity map of the coil is made smoother, and phase-pole artifacts are reduced, for example.

### Second embodiment

The first embodiment has described a case in which the magnetic resonance data serving as a basis for the first reconstructed image 12 used for generating the second sensitivity map 13 is the magnetic resonance data 10, but the magnetic resonance data serving as a basis for the first reconstructed image 12 may be data different from the magnetic resonance data 10. For example, the processing circuit 150 may generate the first reconstructed image by performing SENSE reconstruction (Pruessmann KP, Weiger M, Scheidegger MB, Boesiger P., SENSE: sensitivity encoding for fast MRI. Magn Reson Med 1999; 42: 952-962.) on a third sensitivity map as a sensitivity map obtained by scanning other than that for the magnetic resonance data based on the first sensitivity map 11 by the first reconstruction function 150d. Herein, the SENSE reconstruction is a reconstruction method that is also called SENSE unfolding or coil combining.

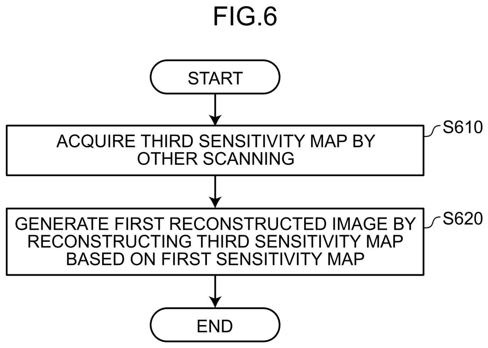

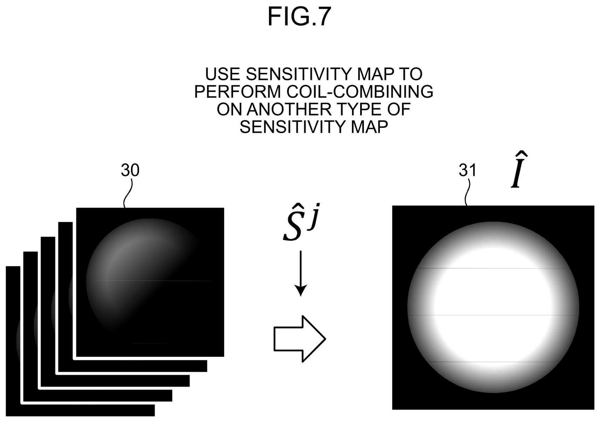

The following describes examples thereof with reference to FIG. 6 and FIG. 7. FIG. 6 is a flowchart for explaining an example of a processing procedure performed by the magnetic resonance imaging apparatus 100 according to a second embodiment, and FIG. 7 is a diagram for explaining processing performed by the magnetic resonance imaging apparatus 100 according to the second embodiment. Herein, in the second embodiment, at Step S200 illustrated in FIG. 2, processing at Step S610 to S620 in FIG. 6 is performed instead of performing the processing at Step S210 to S230 illustrated in FIG. 4 as in the first embodiment. That is, in the second embodiment, Step S610 to S620 in FIG. 6 correspond to Step S200 in FIG. 2.

In the second embodiment, at Step S610, the processing circuit 150 acquires a third sensitivity map 30 by the first reconstruction function 150d. By way of example, the processing circuit 150 acquires the third sensitivity map 30 that is acquired by scanning other than scanning related to the magnetic resonance data 10 by the first reconstruction function 150d. This third sensitivity map 30 is a sensitivity map related to a plurality of the coils, and is a sensitivity map for each coil. Subsequently, at Step S620, the processing circuit 150 generates the first reconstructed image 12 by performing SENSE reconstruction on the third sensitivity map 30 based on the first sensitivity map 11 by the first reconstruction function 150d.

Subsequently, at Step S300, the processing circuit 150 generates the second sensitivity map 13 by multiplying the first sensitivity map 11 by a correction amount that is obtained based on the phase portion of the first reconstructed image 12 obtained as described above by the second generation function 150e. Subsequently, at Step S400, the processing circuit 150 generates the second reconstructed image 14 by reconstructing the magnetic resonance data 10 based on the second sensitivity map 13 obtained at Step S300 by the second reconstruction function 150f.

In this manner, in the second embodiment, the processing circuit 150 generates the first reconstructed image 12 for correcting the first sensitivity map 11 based on data other than the magnetic resonance data 10, for example, the third sensitivity map 30 obtained by the other scanning. Due to this, the sensitivity map of the coil can be corrected by using a sensitivity map obtained by another scanning method. The phase φ of the first reconstructed image 12 obtained in the present embodiment satisfies a condition represented by the following expression (3). $ϕ = {argmin}_{ϕ} {\sum }_{j} {\left|{\hat{S}}^{j}⋅{e}^{iϕ}-{S}_{ext}^{j}\right|}^{2}$

Herein, S^^{j} (with hat symbol) represents the first sensitivity map 11, and Sₑₓₜ^{j} represents the third sensitivity map 30. In other words, the present embodiment corresponds to obtaining the phase φ that can minimize a difference between the first sensitivity map 11 and the third sensitivity map 30.

### Third Embodiment

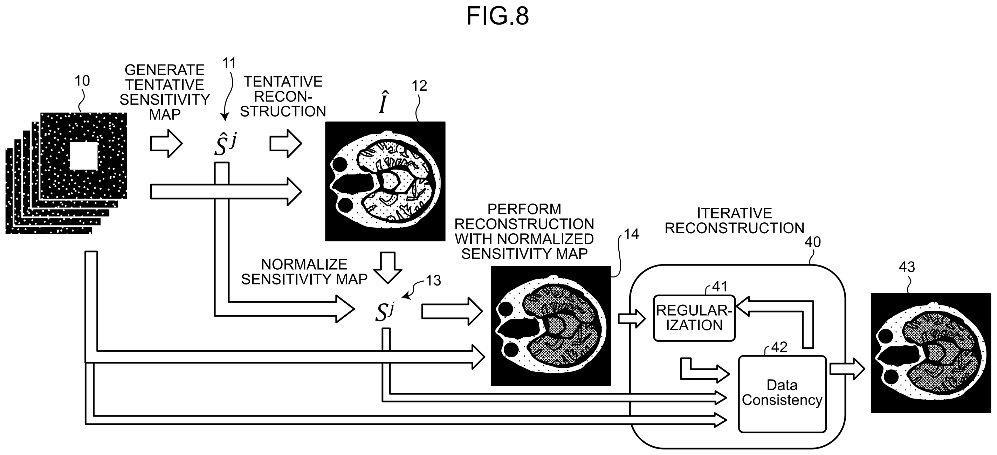

A third embodiment describes a case of combining an iterative reconstruction method and the method according to the first embodiment. FIG. 8 is a flowchart for describing processing performed by the magnetic resonance imaging apparatus 100 according to the third embodiment. Herein, generation of the first sensitivity map 11, the first reconstructed image 12, the second sensitivity map 13, and the second reconstructed image 14 has been described in the first embodiment with reference to FIG. 3. Additionally, in the third embodiment, the processing circuit 150 generates a third reconstructed image 43 by performing iterative reconstruction 40 based on the second sensitivity map 13 and the second reconstructed image 14 by the second reconstruction function 150f. The iterative reconstruction 40 is performed such that the second reconstructed image 14 is input as an initial value, and regularization processing

41 and data consistency processing 42 are repeated until an end condition is satisfied. As the regularization processing 41, for example, processing such as wavelet denoising or machine learning can be exemplified. The data consistency processing 42 is processing of deforming input data so that the input data maintains consistency. As illustrated in FIG. 8, in the data consistency processing 42 at each step of the iterative reconstruction 40, the processing circuit 150 performs reconstruction of data at the next step based on the second sensitivity map 13, the magnetic resonance data 10, and a result of the regularization processing 41 by the second reconstruction function 150f.

In the third embodiment, by inputting the second sensitivity map 13 obtained by the method according to the first embodiment as a value of the sensitivity map input at each step of the iterative reconstruction 40, a phase to be obtained can be made smooth, and accuracy of the iterative reconstruction can be improved. This method suggested herein can effectively reduce artifacts irrespective of a type of a regularization method.

The several embodiments have been described above, but these embodiments are merely examples, and do not intend to limit the scope of the invention. These embodiments can be implemented in various other forms, and can be variously omitted, replaced, modified, or combined with each other without departing from the gist of the invention. These embodiments and modifications thereof are encompassed by the scope and the gist of the invention, and similarly encompassed by the invention described in claims and equivalents thereof.

According to at least one of the embodiments described above, image quality can be improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the scope of the inventions as defined by the appended claims. The accompanying claims are intended to cover such forms or modifications as would fall within the scope of the inventions.

## Claims

1. A magnetic resonance imaging apparatus (100) comprising:
a processing circuit (150) configured to
generate a first sensitivity map (11) based on magnetic resonance data (10),
generate a first reconstructed image (12) by performing reconstruction based on the first sensitivity map (11),
generate a second sensitivity map (13) based on the first reconstructed image (12) and the first sensitivity map (11), and
generate a second reconstructed image (14) by reconstructing the magnetic resonance data (10) based on the second sensitivity map (13).

2. The magnetic resonance imaging apparatus (100) according to claim 1, wherein the processing circuit (150) is configured to generate the first sensitivity map (11) based on the magnetic resonance data (10) as k-space data that is collected by a plurality of coils from an object to be imaged.

3. The magnetic resonance imaging apparatus (100) according to claim 2, wherein the processing circuit (150) is configured to generate the second sensitivity map (13) by correcting indeterminacy of the first sensitivity map (11).

4. The magnetic resonance imaging apparatus (100) according to any one of claims 1 to 3, wherein the processing circuit (150) is configured to generate the first sensitivity map (11) by using an ESPIRiT method for the magnetic resonance data (10).

5. The magnetic resonance imaging apparatus (100) according to claim 1, wherein the processing circuit (150) is configured to generate the first reconstructed image (12) by reconstructing the magnetic resonance data (10) based on the first sensitivity map (11).

6. The magnetic resonance imaging apparatus (100) according to any one of claims 1 to 5, wherein the processing circuit (150) is configured to generate the first reconstructed image (12) by reconstructing data obtained by extracting data in a vicinity of a center of a k-space from the magnetic resonance data (10) based on the first sensitivity map (11).

7. The magnetic resonance imaging apparatus (100) according to claim 1, wherein the processing circuit (150) is configured to generate the first reconstructed image (12) by performing SENSE reconstruction on a third sensitivity map based on the first sensitivity map (11).

8. The magnetic resonance imaging apparatus (100) according to claim 7, wherein the third sensitivity map is a sensitivity map obtained by scanning other than scanning for the magnetic resonance data (10).

9. The magnetic resonance imaging apparatus (100) according to claim 1, wherein the processing circuit (150) is configured to generate the second sensitivity map (13) by multiplying the first sensitivity map (11) by a correction amount that is obtained based on a phase portion of the first reconstructed image (12).

10. The magnetic resonance imaging apparatus (100) according to claim 1, wherein
the processing circuit (150) is configured to
generate a third reconstructed image by performing iterative reconstruction based on the magnetic resonance data (10), the second sensitivity map (13), and the second reconstructed image (14), and
perform reconstruction based on the second sensitivity map (13) at each step of the iterative reconstruction.

11. A magnetic resonance imaging method comprising:
generating a first sensitivity map (11) based on magnetic resonance data (10);
generating a first reconstructed image (12) by performing reconstruction based on the first sensitivity map (11);
generating a second sensitivity map (13) based on the first reconstructed image (12) and the first sensitivity map (11); and
generating a second reconstructed image (14) by reconstructing the magnetic resonance data (10) based on the second sensitivity map (13).
